Europäisches Patentamt

**European Patent Office**

Office européen des brevets

(11) Publication number : **0 310 248 B1**

# EUROPEAN PATENT SPECIFICATION

(45) Date of publication of patent specification :
**25.03.92 Bulletin 92/13**

(51) Int. Cl.⁵ : **H01L 39/24, H01J 37/30, G03G 5/02**

(21) Application number : **88308081.4**

(22) Date of filing : **01.09.88**

(54) **Patterning thin film superconductors using focused beam techniques.**

(30) Priority : **08.12.87 US 130135
30.09.87 US 103245**

(43) Date of publication of application :
**05.04.89 Bulletin 89/14**

(45) Publication of the grant of the patent :
**25.03.92 Bulletin 92/13**

(84) Designated Contracting States :
**DE FR GB**

(56) References cited :
**EP-A- 0 292 387**

(73) Proprietor : **GENERAL MOTORS CORPORATION
General Motors Building 3044 West Grand Boulevard
Detroit Michigan 48202 (US)**

(72) Inventor : **Mantese, Joseph Vito
61331 Windwood Ct.
Washington Michigan 48094 (US)**
Inventor : **Micheli, Adolph Louis
38900 Elmite
Mt. Clemens Michigan 48045 (US)**
Inventor : **Hamdi, Aboud Halal
3988 Dorothy St.
Detroit Michigan 48211 (US)**
Inventor : **Catalan, Antonio Buddy
3658 Merrimac
Sterling Heights Michigan 48077 (US)**

(74) Representative : **Haines, Arthur Donald et al
Patent Section Vauxhall Motors Limited 1st
Floor Gideon House 26 Chapel Street
Luton, Bedfordshire LU1 2SE (GB)**

## Description

This invention relates to superconducting materials. More particularly, this invention relates to methods for patterning films of superconducting materials as specified in the claim 1. A similar technique for metallic films is disclosed in the article entitled "Metal deposition by electron beam exposure of an organometallic film" by Craighead and Schiavone, published in Appl. Phys. Lett. 48 (25) on 23 June 1986.

## Background of the Invention

Films of superconducting materials have been formed using metallo-organic deposition techniques. Superconducting films formed by metallo-organic deposition offer many advantages over standard methods for film preparation and deposition. A significant advantage is that the metallo-organic deposition process does not require vacuum processing. In addition, the chemical constituents of the films may be altered with ease.

Examples of such superconducting materials prepared using metallo-organic deposition techniques, are disclosed in our co-pending patent application in Europe Serial No. 0 310 245, filed on the same date, and herein incorporated by reference.

Metallo-organic deposition of the thin film superconductors generally involves a three-step process. First, an organic liquid, such as the composition comprising yttrium, barium, and copper neodecanoates disclosed in the aforesaid patent application in Europe, is spin-coated onto a suitable substrate. The organic film is then cured in air at about 500°C for about five minutes. Finally, the organic film is baked in an oxygen-containing atmosphere for about six hours at about 850°C, and slow-cooled to room temperature. The resulting empirical composition for the superconducting thin films prepared in accordance with the metallo-organic deposition techniques is $Y_1Ba_2Cu_4O_z$, with z ranging between about 6-8. Electrical measurements indicate a superconducting transition temperature of about 90°K for these superconducting materials, with the temperature of zero state resistance as high as about 70°K.

It is desirable to provide a method for patterning films of superconducting material.

## Summary of the Invention

A method for producing patterned films of superconductor materials according to the present invention is characterised by the features specified in the characterising portion of claim 1.

It is an object of the present invention to provide patterned films of superconductor material.

It is a further object of this invention to provide a method for forming patterned films of superconductor material.

It is still a further object of this invention that these patterned superconductor films be formed using focused beam techniques.

In accordance with a preferred embodiment of this invention, these and other objects and advantages are accomplished as follows.

For the first time a method is disclosed for forming patterned superconductor films by patterning metal neodecanoate organic films, which subsequently are reduced to superconducting films of YBaCuO, and exposing the neodecanoates contained within the metallo-organic films to focused beams of radiation.

Initially a yttrium, barium, copper neodecanoate solution is spin-coated onto a suitable substrate, much like conventional photo-resist liquid is spun onto a silicon wafer. The solvent within the neodecanoate solution is driven off from the organic film by pre-baking the film and substrate at a temperature below the decomposition temperature for the metal neodecanoates, about 25-450°C, for a short period of time, of about five minutes. The metal neodecanoate organic film is still soluble in a xylene-pyridine solvent solution after this pre-baking step. The pre-baked metal neodecanoate organic film is then patterned, by exposing selected areas of the organic film to focused beams of radiation such as electrons, ions, or laser light. This exposure renders the metal neodecanoate material insoluble in the xylene-pyridine mixture where the focused beams of radiation have impinged upon the organic film.

The pre-baked organic film and substrate is then rinsed in the xylene-pyridine solution which acts as a developer to remove the unexposed regions of the organic film, so that only the portions of the metal neodecanoate film which have been exposed to the focused beams remain on the substrate. The substrate and patterned metallo-organic film is then fully cured at 500°C for about five minutes, so as to fully decompose the metal neodecanoates and leave only the corresponding metal oxides on the substrate surface. The cured metal oxide film is subsequently annealed in an oxygen atmosphere at about 850-1000°C for a period of time up to about 60 minutes, cooled to about 200°C, and rapid quenched to room temperature. The resulting patterned material is superconductive.

Other objects and advantages of this invention will be better appreciated from a detailed description thereof, which follows.

## Detailed Description of the Invention

In the present invention, organic inks are prepared using the neodecanoates of yttrium, barium, and copper. Yttrium and barium neodecanoates were formed from their metal acetates by reaction with ammonium neodecanoate. The copper neodecanoate was formed by a reaction of copper(II) acetate with tetramethyl ammonium neodecanoate. Several solutions containing the three neodecanoates, of various concentrations, were made by dissolving the three components in a solvent containing appropriate amounts of xylene and pyridine.

The solution, i.e., ink, which resulted in the preferred superconductor film composition of $YBa_2Cu_4O_z$ has a ratio of one gram of the combined metal neodecanoates to one millilitre of solvent. 8.54 grams of yttrium neodecanoate, 19.12 grams of barium neodecanoate, and 13.76 grams of copper neodecanoate, yielding a total of 41.42 grams of metal neodecanoate, were dissolved in 41.42 millilitres of solvent, the solvent comprising 39.35 millilitres of xylene with 2.07 millilitres of pyridine. The usual solvent for the metal neodecanoates is pure xylene, however, it was observed that the yttrium neodecanoate gels in xylene, forming an unusable ink. Therefore, the addition of approximately five volume percent pyridine to the xylene forms a solvent that will not gel the yttrium neodecanoate. The solutions were filtered to remove particles down to approximately 200 nanometres size.

The inks prepared from the metal neodecanoates and solvents were flooded onto single crystal strontium titanate, $SrTiO_3$, substrates, oriented in the <100> crystal direction. The inks were spun dry on the substrates at various speeds, about 2000 revolutions per minute for about 20 seconds being preferred, although suitable results have been obtained using 1000-10000 revolutions per minute.

The xylene-pyridine solvent within the metal neodecanoate solution is driven off from the metal neodecanoate organic film by pre-baking the film and substrate in air at a temperature less than the decomposition temperature for the metal neodecanoates, i.e., about 25-450°C, for a short period of time, preferably at a temperature of about 110°C for about five minutes. At this point, after the pre-baking step at a temperature less than the metal neodecanoate decomposition temperature, the organic neodecanoate film is still soluble in a xylene-pyridine solvent solution. The pre-baked organic neodecanoate film is then patterned, by exposing selected areas of the organic film to focused beams of electrons, ions, or laser light. This exposure renders the material insoluble in the xylene-pyridine mixture where the focused beams have impinged upon the organic film.

The three focused beam techniques employed to form the patterned superconductor films are, respectively, electron beam, ion beam, and laser beam techniques. Using electron beam techniques, selected areas of the pre-baked metal neodecanoate organic films are exposed to an electron beam having an energy ranging between about 20-50 keV. The diameter of the focused beam may vary between about 5-500 nanometres, therefore resulting in superconducting patterns of various dimensions.

The electron beam renders the exposed regions of the metal neodecanoate organic film insoluble in the xylene-pyridine solvent solution. The pre-baked substrate and metal neodecanoate organic film, which has been selectively exposed to the focused electron beam, are then rinsed in the xylene-pyridine solution.

The xylene-pyridine solvent solution acts in an analogous manner to that of a photographic fixer solution, so as to remove the unexposed regions of the organic film. Therefore, only the selectively-exposed portions of the metal neodecanoate organic film remain on the substrate.

The patterned metallo-organic film is then fully cured at about 500°C for about five minutes, so as to fully decompose the metal neodecanoates and leave only the metal oxides on the substrate surface. Complete decomposition of the combined neodecanoates occurs at about 450°C. The cured metal oxide film is subsequently annealed in an oxygen atmosphere at about 850-1000°C for a duration ranging up to to about 60 minutes, to promote recrystallization and grain growth. The film is cooled to about 200°C and rapid-quenched to room temperature. The first cooling step to about 200°C may range between either substantially instantaneously, i.e., quenched, or a slow cooling rate, i.e., about 100°C per hour, as no particular rate of cooling is preferred. The resulting patterned material is superconductive and has a preferred relative metal composition of $YBa_2Cu_4O_z$, with z ranging between about 6-8.

The pre-baked metal-neodecanoate organic films may also be patterned using ion beam methods. The focused ion beam generally requires shorter exposure times and lower ion dosages, as compared to exposing the material using focused electron beam methods, because the ions have a greater mass than the electrons, and therefore impart more energy. After the metal neodecanoate organic films have been pre-baked, so as to drive off the organic xylene-pyridine solvent present in the films, the films may be patterned using a focused ion beam.

Generally, any ion-forming element may be used to form the focused ion beam, so as to pattern the metal neodecanoate organic films. However, the preferred focused ion beams for patterning these metal neodecanoate films are gallium ($Ga^+$), boron ($B^+$ or $B^{++}$), oxygen ($O^+$ or $O^{++}$), phosphorus ($P^+$ or $P^{++}$), or silicon ($Si^+$ or $Si^{++}$). The preferred patterning results are obtained for these various materials, using an ion beam energy of about 10-400 keV, a dosage of about $10^{13} - 10^{16}$ ions per square centimetre, and a focused beam diameter of about 5-500 nanometres. The metal neodecanoate material which has been exposed to the focused ion beams is rendered insoluble in xylene-pyridine solvent solution. Thus the ion beam method renders those selective areas that have been exposed to the focused ion beam insoluble in the xylene pyridine solvent subsequently applied to the exposed films. Therefore, similarly to the electron beam method disclosed above, only those areas which have not been exposed to the focused beam remain soluble in the xylene-pyridine solvent.

After the metal neodecanoate films have been exposed to the focused ion beam, the substrate and films are rinsed in the xylene-pyridine solvent solution which acts in the same manner as a photographic fixer solution to remove the unexposed regions of the organic film. After rinsing in the xylene-pyridine solvent solution, only the selectively-exposed portions of the organic neodecanoate films remain on the substrate. The patterned metal neodecanoate organic films on the substrate are then fully cured at 500°C for about five minutes, so as to fully decompose the metal neodecanoates. Complete decomposition of the metal neodecanoates occurs at about 450°C. Therefore only the metal oxides remain on the substrate surface after the curing step. The cured metal oxide films are subsequently annealed in an oxygen atmosphere at about 850-1000°C for a duration ranging up to about 60 minutes. The films are then cooled to about 200°C, and rapid-quenched to room temperature. The cooling step to 200°C may vary between instantaneous cooling i.e., quenching, or slow cooling, i.e., about 100°C per hour, as no particular rate is preferred. The resulting patterned films are superconductive and have a preferred relative metal composition of $YBa_2Cu_4O_z$, with z ranging between about 6-8.

The third method which is disclosed for forming patterned superconductive films involves laser beam techniques. The pre-baked metal neodecanoate organic films, which have been spun-on to the appropriate substrate, such as strontium titanate, are patterned using laser beam methods. The focused laser beam exposes selective regions of the metal neodecanoate films, by imparting heat to the selected regions of the material and rendering that material insoluble in xylene-pyridine solvent solution. An advantage of the laser beam method is that the focused laser beam may locally heat the desired areas above the metal neodecanoate decomposition temperature of about 450°C, therefore eliminating the curing step after patterning required with the electron beam or ion beam methods hereinbefore disclosed.

After the metal neodecanoate organic films have been pre-baked at a temperature less than the metal neodecanoate decomposition temperature, so as to drive off the organic xylene-pyridine solvent present therein, the films are patterned by exposing the selected areas of the film to a focused laser beam. Preferably, the focused laser beam has a beam diameter of about 100-1000 nanometres and a beam energy of about 0.1-100 Watts. Generally, the wavelength of the laser beam does not significantly affect the results of the exposure. The focused laser beam renders those selective areas that have been exposed to the focused laser beam insoluble in xylene-pyridine solvent solution. Further, depending on the parameters of the laser beam employed, those selected areas will also be locally cured if the laser beam imparts enough localized heat to raise the temperature of the films above the metal neodecanoate decomposition temperature of about 450°C. This eliminates the need for the subsequent curing step, which is necessary for the electron beam and ion beam methods.

After the metal neodecanoate films have been exposed to the focused laser beam, the substrate and films are rinsed in the xylene-pyridine solvent solution which acts in the same manner as a photographic fixer solution to remove the unexposed regions of the organic films. The rinsing step occurs regardless of whether the exposed areas had been heated above the metal neodecanoate decomposition temperature. After rinsing in the xylene-pyridine solvent solution, only the selectively exposed, insoluble portions of the organic neodecanoate films remain on the substrate. The substrate and patterned metal neodecanoate organic films are fully cured at 500°C for about five minutes, so as to fully decompose the metal neodecanoates. The curing step is optional depending on whether the focused laser beam parameters are such that complete decomposition of the metal neodecanoates will occur. After decomposition of the metal neodecanoates, whether by the focused laser beam or subsequent curing step, only the metal oxides remain on the substrate surface. The cured metal oxide films are subsequently annealed in an oxygen atmosphere at about 850-1000°C for a duration ranging up to about 60 minutes, so as to promote recrystallization and grain growth. This is followed by cooling the films to about 200°C, the cooling rate being between instantaneous quenching to a very slow cooling rate of about 100°C per hour. The films are then rapid-quenched to room temperature. The resulting patterned film is superconductive and has a preferred relative metal composition of $YBa_2Cu_4O_z$, with z ranging between about 6-8.

With this invention, superconducting thin films of various compositions may be formed. This invention readily facilitates modification of the focused beam parameters, metal constituents, and their ratios within the thin films, and patterned configurations, to obtain optimal superconducting film characteristics.

## Claims

1. A method for producing patterned films of superconductor materials by the irradiation of a metallo-organic film deposited on a substrate to expose selected regions of said film in a predefined pattern, the method comprisings the steps of: forming a solution from the neodecanoates of metals, which metals can form an oxide mixture exhibiting superconductive properties, said solution being soluble in an organic solvent; depositing as said metallo-organic film a film of said solution onto said substrate; exposing said selected regions of said film to radiation so that said exposed selected regions of said film become insoluble in said organic solvent; immersing said film into said organic solvent so that removal of unexposed regions of said film with said organic solvent allows said insoluble, exposed regions of said film to remain on said substrate; heating said film at a first temperature for a period of time that is (a) sufficient to thermally decompose said metal neodecanoates in said insoluble, exposed regions of said film into the corresponding metal oxides, and (b) insufficient to significantly recrystallize said metal oxides; and heating said metal oxide exposed regions at a second temperature for a period of time that is sufficient to promote recrystallization and grain growth of said metal oxides within said exposed regions and to induce a change therein by which said exposed regions of said film exhibit superconducting properties.

2. A method for producing patterned films of superconductor materials according to claim 1, characterised in that said film is exposed to radiation in the form of a focused beam of radiation.

3. A method for producing patterned films of superconductor materials according to claim 2, characterised in that the focused beam of radiation is an electron beam.

4. A method for producing patterned films of superconductor material according to claim 3, characterised in that said focused electron beam has a beam diameter ranging between about 5 to about 500 nanometres, and has an energy level ranging between about 20 to about 50 keV.

5. A method for producing patterned films of superconductor materials according to claim 2, characterised in that the focused beam of radiation is an ion beam.

6. A method for producing patterned films of superconductor material according to claim 5, characterised in that the ion beam is formed from ions of gallium, boron, oxygen, phosphorus, or silicon.

7. A method for producing patterned films of superconductor material according to claim 5 or 6, characterised in that said focused ion beam has a beam diameter ranging between about 5 to about 500 nanometres, an energy level ranging between about 10 to about 400 keV, and produces an ion dosage ranging between about $10^{13}$ to about $10^{16}$ ions per square centimetre.

8. A method for producing patterned films of superconductor materials according to claim 2, characterised in that the focused beam of radiation is a laser beam.

9. A method for producing patterned films of superconductor material according to claim 8, characterised in that said focused laser beam has a beam diameter ranging between about 100 to about 1000 nanometres, and said laser beam has an energy level ranging between about 0.1 to about 100 Watts.

10. A method for producing patterned films of superconductor materials according to any one of the preceding claims, characterised in that said solution contains the metal neodecanoates of yttrium, barium, and copper.

11. A method for producing patterned films of superconductor material according to any one of the preceding claims, characterised in that said organic solvent comprises a mixture of xylene and pyridine.

12. A method for producing patterned films of superconductor materials according to any one of the preceding claims, characterised in that the first temperature at which the film is heated is greater than 450°C, and the second temperature at which the film is heated ranges between about 850°C to about 1000°C.

13. A patterned film of superconductor material produced in accordance with any one of the methods of the preceding claims.


**Patentansprüche**

1. Verfahren zur Herstellung von strukturierten Filmen aus supraleitenden Materialien durch die Bestrahlung eines an einem Substrat abgeschiedenen metallorganischen Filmes, um ausgewählte Bereiche des Filmes in einer vorbestimmten Struktur Strahlung auszusetzen, wobei das Verfahren folgende Schritte umfaßt: es wird eine Lösung aus den Neodecanoaten von Metallen gebildet, welche Metalle ein supraleitende Eigenschaften aufweisendes Oxidgemisch bilden können, wobei die Lösung in einem organischen Lösungsmittel löslich ist; ein Film der Lösung wird als der metallorganische Film auf dem Substrat abgeschieden; die ausgewählten Bereiche des Films werden Strahlung ausgesetzt, so daß die ausgesetzten ausgewählten Bereiche des Films in dem organischen Lösungsmittel unlöslich werden; der Film wird in das organische Lösungsmittel eingetaucht, so daß die Entfernung der nicht ausgesetzten Bereiche des Films mit dem organischen Lösungsmittel den unlöslichen ausgesetzten Bereichen des Filmes an dem Substrat ein Verbleiben erlaubt; der Film wird bei einer ersten Temperatur während einer Zeitdauer ausgeheizt, die (a) ausreicht, um die Metalldecanoate in den unlöslichen, der Strahlung ausgesetzt gewesenen Bereichen des Filmes thermisch in die entsprechenden Metalloxide zu zersetzen und (b) nicht ausreicht, um die Metalloxide beträchtlich umzukristallisieren; und die der Strahlung ausgesetzt gewesenen Metalloxidbereiche werden bei einer zweiten Temperatur während einer Zeitdauer ausgeheizt, die ausreicht, Rekristallisation und Kornwachstum der Metalloxide innerhalb der ausgesetzten Bereiche zu fördern und eine Änderung darin zu induzieren, durch welche die ausgesetzt gewesenen Bereiche des Filmes supraleitende Eigenschaften zeigen.

2. Verfahren zur Erzeugung strukturierter Filme aus supraleitenden Materialien nach Anspruch 1, dadurch gekennzeichnet, daß der Film Strahlung in Form eines fokussierten Strahls einer Strahlung ausgesetzt wird.

3. Verfahren zur Erzeugung strukturierter Filme aus supraleitenden Materialien nach Anspruch 1, dadurch gekennzeichnet, daß der fokussierte Strahl einer Strahlung ein Elektronenstrahl ist.

4. Verfahren zur Erzeugung strukturierter Filme aus supraleitendem Material nach Anspruch 3, dadurch gekennzeichnet, daß der fokussierte Elektronenstrahl einen Strahldurchmesser im Bereich zwischen etwa 5 bis etwa 500 nm und einen Energiepegel im Bereich zwischen etwa 20 bis etwa 50 keV besitzt.

5. Verfahren zur Erzeugung strukturierter Filme aus supraleitendem Material nach Anspruch 2, dadurch gekennzeichnet, daß der fokussierte Strahl einer Strahlung ein Ionenstrahl ist.

6. Verfahren zur Erzeugung strukturierter Filme aus supraleitendem Material nach Anspruch 5, dadurch gekennzeichnet, daß der Ionenstrahl aus Gallium-, Bor-, Sauerstoff-, Phosphor- oder Silizium-Ionen gebildet ist.

7. Verfahren zur Erzeugung strukturierter Filme aus suparaleitendem Material nach Anspruch 5 oder 6, dadurch gekennzeichnet, daß der fokussierte Ionenstrahl einen Strahldurchmesser im Bereich zwischen etwa 5 bis etwa 500 nm und einen Energiepegel im Bereich von etwa 10 bis etwa 400 keV besitzt und eine Ionendosierung im Bereich zwischen $10^{13}$ bis eta $10^{16}$ Ionen pro $cm^2$ erzeugt.

8. Verfahren zur Erzeugung strukturierter Filme aus supraleitendem Material nach Anspruch 2, dadurch gekennzeichnet, daß der fokussierte Strahl einer Strahlung ein Laserstrahl ist.

9. Verfahren zur Erzeugung strukturierter Filme aus supraleitendem Material nach Anspruch 8, dadurch gekennzeichnet, daß der fokussierte Laserstrahl einen Strahldurchmesser im Bereich zwischen 100 bis 1000 nm besitzt und der Laserstrahl einen Energiepegel zwischen etwa 0,1 bis etwa 100 W besitzt.

10. Verfahren zur Erzeugung strukturierter Filme aus supraleitendem Material nach einem der vorangehenden Ansprüche, dadurch gekennzeichnet, daß die Lösung die Metallneodecanoate von Yttrium, Barium und Kupfer enthält.

11. Verfahren zur Erzeugung strukturierter Filme aus supraleitendem Material nach einem der vorangehenden Ansprüche, dadurch gekennzeichnet, daß das organische Lösungsmittel ein Gemisch aus Xylol und Pyridin umfaßt.

12. Verfahren zur Erzeugung strukturierter Filme aus supraleitendem Material nach einem der vorangehenden Ansprüche, dadurch gekennzeichnet, daß die erste Temperatur, auf welche der Film aufgeheizt wird, höher als 450°C liegt und die zweite Temperatur, auf welche der Film aufgeheizt wird, zwischen etwa 850°C bis etwa 1000°C liegt.

13. Strukturierter Film aus Supraleitermaterial, der entsprechend einem der Verfahren der vorangehenden Ansprüche erzeugt wurde.


**Revendications**

1. Procédé de fabrication de films configurés à base de matériaux supraconducteurs par irradiation d'un film organométallique déposé sur un substrat afin d'exposer des zones choisies dudit film en une configuration prédéfinie procédé consistant à: former une solution de néodéoanoates de métaux pouvant engendrer un mélange d'oxydes présentant des propriétés supraconductrices ledit mélange étant soluble dans un solvant organique; déposer comme film organométallique un film de ladite solution sur ledit substrat; exposer lesdites zones choisies dudit film à l'irradiation de telle sorte que lesdites zones choisies exposées dudit film deviennent insolubles dans ledit solvant organique; immerger ledit film dans ledit solvant organique de manière à ce que l'élimination des zones non exposées dudit film par ledit solvant organique permette auxdites zones exposées insolubles dudit film de rester sur ledit substrat; chauffer ledit film à une première température pendant une durée qui est (a) suffisante pour décomposer thermiquement en les oxydes métalliques correspondants lesdits néodécanoates métalliques dans lesdites zones exposées insolubles dudit film et (b) insuffisante pour recristalliser de façon importante lesdits oxydes métalliques; et chauffer lesdites zones exposées à base d'oxydes métalliques à une seconde température pendant une durée suffisante pour favoriser la recristallisation et la croissance granulaire desdits oxydes métalliques au sein des zones exposées et y induire une modifioation grâce à laquelle lesdites zones exposées dudit film présentent des propriétés supraconductrices.

2. Procédé de fabrication de films configurés à base de matériaux supraconducteurs selon la revendication 1, caractérisé en ce que ledit film est exposé à une irradiation sous forme d'un faisceau focalisé de rayons.

3. Procédé de fabrication de films configurés à base de matériaux supraconducteurs selon la revendication 2 caractérisé en ce que le faisceau focalisé de rayons est un faisceau d'électrons.

4. Procédé de fabrication de films configurés à base de matériaux supraconducteurs selon la revendication 3 caractérisé en ce que le faisceau focalisé d'électrons a un diamètre compris entre environ 5 et environ 500 nm et un niveau d'énergie compris entre environ 20 et environ 50 KeV.

5. Procédé de fabrication de films configurés à base de matériaux supraconducteurs selon la revendication 2 caractérisé en ce que le faisceau focalisé de rayons est un faisceau d'ions.

6. Procédé de fabrication de films configurés à base de matériaux supraconducteurs selon la revendication 5 caractérisé en ce que le faisceau d'ions est constitué d'ions gallium, bore oxygène phosphore ou silicium.

7. Procédé de fabrication de films configurés à base de matériaux supraconducteurs selon la revendication 5 ou 6 oaractérisé en ce que ledit faisceau focalisé d'ions a un diamètre compris entre environ 5 et environ 500 nm et un niveau d'énergie compris entre environ 10 et environ 400 keV et qu'il produit une dose d'ions comprise entre environ $10^{13}$ et $10^{16}$ ions par $cm^2$.

8. Procédé de fabrication de films configurés à base de matériaux supraconducteurs selon la revendication 2, caractérisé en ce que le faisceau focalisé de rayons est un faisceau laser.

9. Procédé de fabrication de films configurés à base de matériaux supraconducteurs selon la revendication 8 caractérisé en ce que ledit faisceau laser focalisé a un diamètre compris entre environ 100 et environ 1000 nm et un niveau d'énergie compris entre environ 0,1 et enviren 100 W.

10. Procédé de fabrication de films configurés à base de matériaux supraconducteurs selon l'une quelconque des revendications précédentes caractérisé en ce que ladite solution renferme les néodécanoates métalliques d'yttrium de baryum et de cuivre.

11. Procédé de fabrication de films configurés à base de matériaux supraconducteurs selon l'une quelconque des revendications précédentes caractérisé en ce que ledit solvant organique comprend un mélange de xylène et de pyridine.

12. Procédé de fabrication de films configurés à base de matériaux supraconducteurs selon l'une quelconque des revendications précédentes caractérisé en ce que la première température à laquelle on chauffe le film est supérieure à 450°C et la seconde température à laquelle on chauffe le film est comprise entre environ 850°C et environ 1000°C.

13. Film configuré à base de matériau supraconducteur fabriqué selon l'un quelconque des procédés des revendications précédentes.